(19) Europäisches Patentamt
European Patent Office
Office européen des brevets

(11) **EP 1 212 830 B1**

(12) **EUROPÄISCHE PATENTSCHRIFT**

(45) Veröffentlichungstag und Bekanntmachung des Hinweises auf die Patenterteilung:
**03.11.2004 Patentblatt 2004/45**

(21) Anmeldenummer: 00951793.9

(22) Anmeldetag: **15.08.2000**

(51) Int Cl.⁷: **H03D 7/16**

(86) Internationale Anmeldenummer:
**PCT/IB2000/001179**

(87) Internationale Veröffentlichungsnummer:
**WO 2001/015315 (01.03.2001 Gazette 2001/09)**

(54) **VERFAHREN ZUM AUSREGELN EINES FREQUENZOFFSETS IM EMPFÄNGER EINER BASISSTATION EINES NACHRICHTENÜBERTRAGUNGSSYSTEMS**

METHOD FOR REGULATING A FREQUENCY OFFSET IN A BASE-STATION RECEIVER OF A DATA COMMUNICATIONS SYSTEM

PROCEDE DE REGULATION D'UN DECALAGE DE FREQUENCE DANS LE RECEPTEUR D'UNE STATION DE BASE D'UN SYSTEME DE COMMUNICATION DE DONNEES

(84) Benannte Vertragsstaaten:
**AT BE CH CY DE DK ES FI FR GB GR IE IT LI LU MC NL**

(30) Priorität: **21.08.1999 DE 19939811**

(43) Veröffentlichungstag der Anmeldung:
**12.06.2002 Patentblatt 2002/24**

(73) Patentinhaber: **Marconi Communications GmbH 71522 Backnang (DE)**

(72) Erfinder: **BODENSCHATZ, Wolfgang D-71522 Backnang (DE)**

(74) Vertreter: **Camp, Ronald Marconi Intellectual Property, Crompton Close Basildon, Essex SS14 3BA (GB)**

(56) Entgegenhaltungen:
EP-A- 0 713 298    DE-A- 19 635 533
DE-A- 19 748 913    US-A- 5 493 710
US-A- 5 584 066

**Beschreibung**

Stand der Technik

Die vorliegende Erfindung betrifft ein Verfahren zum Ausregeln eines Frequenzoffsets im Empfänger einer Basisstation eines Nachrichtenübertragungssystems, in dem die Basisstation Nachrichten im Zeitmultiplex an mehrere Teilnehmerstationen aussendet und die Nachrichtenübertragung von den Teilnehmern zur Basisstation im Zeitmultiplex mit Vielfachzugriff erfolgt.

Aus der DE 196 35 533 A1 ist ein Punkt-zu-Mehrpunkt-Funkübertragungssystem bekannt, bei dem die Datenübertragung zwischen einer Basisstation und mehreren Teilnehmerstationen im Zeitmultiplex (TDM/TDMA) erfolgt. Die Basisstation und die Teilnehmerstationen sind prinzipiell gleichartig aufgebaut und besitzen in ihrem Sendezweig einen Modulator, ein oder mehrere Zwischenfrequenz-(ZF)Stufen und eine Hochfrequenz-(HF)Stufe, und sie weisen analog dazu in ihrem Empfangszweig eine RF-Stufe, ein oder mehrere ZF-Stufen und einen Demodulator auf. Die ZF- und die RF-Stufen, der Modulator und der Demodulator besitzen jeweils einen Umsetzer, der von einer Referenzfrequenz angesteuert wird.

Die Referenzfrequenzen werden von Lokaloszillatoren in entsprechenden Frequenzlagen zur Verfügung gestellt.

In dem genannten TDM/TDMA-Nachrichtenübertragungssystem liefert die Basisstation an eine Vielzahl von Teilnehmerstationen Nachrichten in Form eines kontinuierlichen, bezüglich der Zeit gemultiplexten Datenstroms. Jede der vorhandenen Teilnehmerstationen sendet ihre Daten in einem ihr individuell zugewiesenen Zeitschlitz an die Basisstation. Aus der Sicht der Basisstation treffen also nach einem vorgegebenen Zeitplan Datenbursts von verschiedenen Teilnehmerstationen ein. In der Basisstation sollen die einzelnen eintreffenden Datenbursts möglichst fehlerfrei demoduliert werden. Dazu ist es erforderlich, daß der Empfänger der Basisstation sich mit möglichst hoher Genauigkeit auf die Trägerfrequenz der ankommenden Datenbursts einrastet. Voraussetzung dafür ist, daß ein Frequenzoffset zwischen den von der Basisstation empfangenen Datenbursts und dem Frequenznormal der Basisstation möglichst gering, idealerweise Null, wird.

Der Erfindung liegt daher die Aufgabe zugrunde, ein Verfahren der eingangs genannten Art anzugeben, mit dem ein Frequenzoffset im Empfänger einer Basisstation mit möglichst geringem Aufwand ausgeregelt werden kann.

Vorteile der Erfindung

Die genannte Aufgabe wird mit den Merkmalen des Anspruchs 1 dadurch gelöst, daß zunächst in jeder Teilnehmerstation die Referenzfrequenz ihres Demodulators so eingestellt wird, daß dessen Ausgangssignal keinen Trägerfrequenzanteil aufweist. Dann wird aus der so eingestellten Referenzfrequenz für den Demodulator in der betreffenden Teilnehmerstation und aus allen in dieser Teilnehmerstation und in der Basisstation fest vorgegebenen Umsetzer-Referenzfrequenzen eine Referenzfrequenz für den Modulator in dieser Teilnehmerstation unter der Bedingung berechnet, daß eine im Ausgangssignal des Demodulators der Basisstation auftretende, einen Frequenzoffset darstellende, Trägerfrequenz zu Null gesetzt wird. Die Referenzfrequenz für den Demodulator der Teilnehmerstation wird schließlich auf den berechneten Wert eingestellt.

Um einen vorhandenen Frequenzoffset im Empfänger der Basisstation auszuregeln, muß lediglich in den einzelnen Teilnehmerstationen die Referenzfrequenz für den Modulator auf einen Wert eingestellt werden, der sich auf einfache Art und Weise aus bekannten Größen numerisch errechnen läßt.

Vorteilhafte Weiterbildungen der Erfindung gehen aus den Unteransprüchen hervor.

Demnach wird die Referenzfrequenz für den Modulator der Teilnehmerstation aus der Bedingung errechnet, daß die Summe aus den Referenzfrequenzen für die Modulatoren, Demodulatoren und Zwischenfrequenzumsetzer in der Basisstation und in der Teilnehmerstation zu Null gesetzt wird, wobei sowohl in der Basisstation als auch in der Teilnehmerstation die Referenzfrequenzen für die RF-Umsetzer im Empfangs- und Sendezweig gleich aber gegenphasig sind.

Vorzugsweise werden in der Basisstation und in jeder Teilnehmerstation die Referenzfrequenzen für die Frequenzumsetzung im Modulator und Demodulator und für ein oder mehrere Zwischenfrequenzumsetzer von einem Lokaloszillator durch Multiplikation der Lokaloszillatorfrequenz mit entsprechenden Umsetzungsfaktoren gebildet, und die Referenzfrequenzen für RF-Umsetzer werden von einem weiteren Lokaloszillator durch Multiplikation der Lokaloszillatorfrequenz mit entsprechenden Umsetzungsfaktoren erzeugt.

Um einen Frequenzoffset auszuregeln, wird der Umsetzungsfaktor für den Modulator der jeweiligen Teilnehmerstation aus der Bedingung berechnet, daß die Summe aus einem ersten Produkt, das durch Multiplikation der Lokaloszillatorfrequenz der Basisstation mit der Summe aus den Umsetzungsfaktoren für den Modulator und den Demodulator und den Zwischenfrequenz-Umsetzungsfaktoren im Empfangs- und Sendezweig gebildet wird, und aus einem zweiten Produkt, das durch Multiplikation der Lokaloszillatorfrequenz der Teilnehmerstation mit der Summe aus den Umsetzungsfaktoren für den Modulator und Demodulator und den Zwischenfrequenz-Umsetzungfaktoren im Empfangs- und im Sendezweig gebildet wird, zu Null gesetzt wird. Als weitere Bedingung ist dabei einzuhalten, daß sowohl in der Basisstation als auch in den Teilnehmerstationen die Umsetzungsfaktoren für die RF-Umsetzer im Empfangs- und Sendezweig vom Betrag her gleich groß sind aber entgegengesetzte Vorzeichen haben.

Die Lokaloszillatorfrequenz der Basisstation wird vorzugsweise in der Teilnehmerstation aus der Symbolrate der von der Basisstation zur Teilnehmerstation übertragenen Daten hergeleitet.

Zeichnung

Anhand eines in der Zeichnung dargestellten Ausführungsbeispiels wird nachfolgend die Erfindung näher erläutert. Es zeigen:

Figur 1 ein Prinzipschaltbild einer Basisstation und
Figur 2 ein Prinzipschaltbild einer Teilnehmerstation.

Beschreibung eines Ausführungsbeispiels

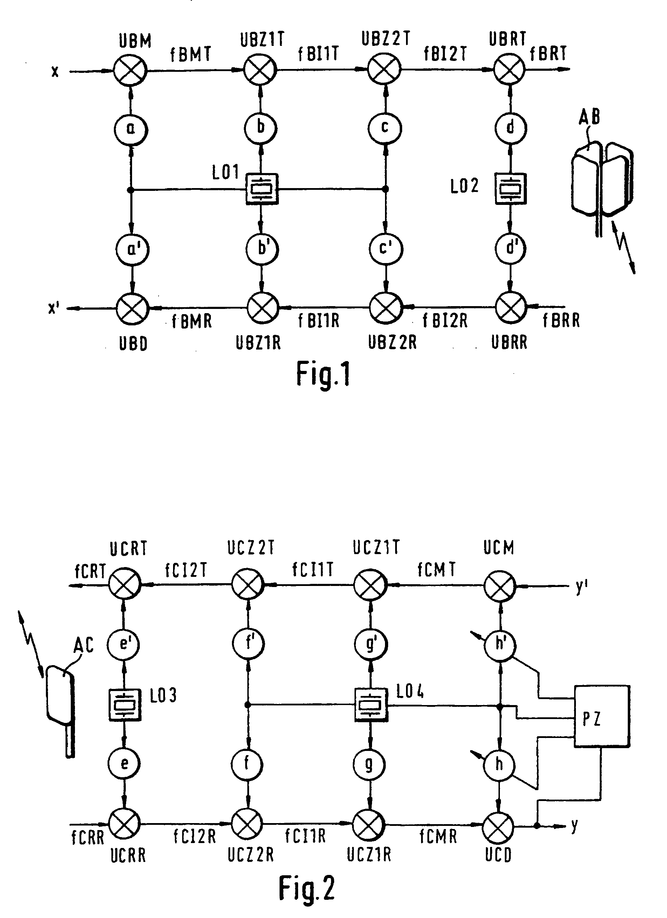

In der Figur 1 ist eine Sende-/Empfangsschaltung einer Basisstation beispielsweise eines Punkt-zu-Mehrpunkt-Funksystems dargestellt. Zwischen dieser Basisstation und mehreren Teilnehmerstationen findet eine Nachrichtenübertragung statt, wobei die Basisstation einen kontinuierlichen zeitgemultiplexten (TDM) Datenstrom an die Teilnehmerstationen aussendet, welche im Zeitmultiplex mit Vielfachzugriff (TDMA) auf Datenbursts in ihnen zugeordneten Zeitschlitzen des Datenstroms zugreifen. In Richtung Basisstation senden die einzelnen Teilnehmerstationen ebenfalls nach dem TDMA-Prinzip ihre Daten in fest zugeordneten Zeitschlitzen aus. In Figur 1 ist eine zu der Basisstation gehörende Sende-/Empfangsantenne AB dargestellt. Sie kann in mehrere Raumsektoren, in denen sich Teilnehmerstationen befinden, Nachrichten aussenden bzw. aus diesen mehreren Sektoren von den Teilnehmerstationen ausgesendete Signale empfangen. Jede Teilnehmerstation, von der in der Figur 2 eine beispielhaft dargestellt ist, besitzt eine Antenne AC, welche auf die Basisstation ausgerichtet ist und Signale von ihr empfangen bzw. an sie aussenden kann.

Da es sich bei der Erfindung um die Ausregelung eines Frequenzoffsets handelt, sind in der in den Figuren 1 und 2 dargestellten Basisstation und Teilnehmerstation ausschließlich alle die Trägerfrequenzen erzeugenden und umsetzenden Schaltungsmittel dargestellt. Von der Darstellung anderer für die Signalverarbeitung erforderlichen Schaltungen ist abgesehen worden.

Im Sendezweig der Basisstation (Figur 1) wird ein Modulationssignal x von einem Umsetzer UBM eines Modulators einem Träger aufmoduliert, der einer mit dem Umsetzungsfaktor a multiplizierten Frequenz eines ersten freilaufenden Lokaloszillators LO1 entspricht. Die aus dem Umsetzer UBM hervorgehende Frequenz fBMT wird einem ersten Zwischenfrequenz-Umsetzer UBZ1T zugeführt. Als Referenzfrequenz erhält dieser Umsetzer UBZ1T die mit dem Umsetzungsfaktor b multiplizierte Frequenz des ersten Lokaloszillators LO1. Die Ausgangsträgerfrequenz fBI1T des ersten ZF-Umsetzers UBZ1T gelangt zu einem zweiten ZF-Umsetzer UBZ2T. Dieser zweite ZF-Umsetzer UBZ2T wird von der mit einem Umsetzungsfaktor c multiplizierten Frequenz des ersten Lokaloszillators LO1 angesteuert. In einem Nachrichtenübertragungssystem können abweichend von dem dargestellten Ausführungsbeispiel auch nur eine einzige oder mehrere als zwei Zwischenfrequenzstufen vorhanden sein.

Die Ausgangsträgerfrequenz fBI2T des zweiten ZF-Umsetzers UBZ2T gelangt an den Eingang eines RF-Umsetzers UBRT. Die Referenzfrequenz für diesen RF-Umsetzer ist die mit einem Umsetzungsfaktor d beaufschlagte Frequenz eines zweiten freilaufenden Lokaloszillators LO2. Am Ausgang des RF-Umsetzers UBRT steht die Sendefrequenz fBRT zur Verfügung.

Im Empfangszweig ist ein RF-Umsetzer UBRR vorhanden, dem die Empfangsfrequenz fBRR zugeführt wird. Die Referenzfrequenz für diesen RF-Umsetzer ist wiederum die von dem zweiten Lokaloszillator LO2 erzeugte, mit einem Umsetzungsfaktor d' multiplizierte Frequenz. Die Ausgangsträgerfrequenz fBI2R des RF-Umsetzers UBRR liegt am Eingang eines ZF-Umsetzers UBZ2R an. Dieser ZF-Umsetzer UBZ2R wird von der mit einem Umsetzungsfaktor c' multiplizierten Frequenz des ersten Lokaloszillators LO1 angesteuert. Ähnlich wie im Sendezweig ist im Empfangszweig auch ein weiterer ZF-Umsetzer UBZ1R vorhanden. Dieser Umsetzer UBZ1R setzt die vom vorhergehenden ZF-Umsetzer UBZ2R gelieferte Trägerfrequenz fBI1R mit Hilfe der von dem ersten Lokaloszillator LO1 stammenden und mit einem Umsetzungsfaktor b' multiplizierten Frequenz in eine Zwischenfrequenz fBMR um. Es folgt ein Umsetzer UBD eines Demodulators, der das in die Zwischenfrequenzebene heruntergesetzte Empfangssignal demoduliert. Als Referenzfrequenz erhält der Umsetzer UBD dazu die vom Lokaloszillator LO1 erzeugte und mit dem Umsetzungsfaktor a' multiplizierte Frequenz. Das demodulierte Basisbandsignal x' steht am Ausgang des Umsetzers UBD zur Verfügung.

Bei der in der Figur 2 dargestellten Teilnehmerstation befindet sich im Sendezweig ein Modulator mit einem Umsetzer UCM, der ein Modulationssignal y' einem Träger aufmoduliert. Dazu erhält der Umsetzer UCM des Modulators eine Referenzfrequenz, die einer mit einem Umsetzungsfaktor h' multiplizierten Frequenz eines ersten freilaufenden Lokaloszillators LO4 entspricht. Die aus dem Umsetzer UCM hervorgehende Trägerfrequenz fCMT wird einem ersten Zwischenfrequenz-Umsetzer UCZ1T zugeführt. Als Referenzfrequenz erhält dieser ZF-Umsetzer UCZ1T die mit dem Umsetzungsfaktor g' multiplizierte Frequenz des ersten Lokaloszillators LO4. Die Ausgangsfrequenz fCI1T des ersten ZF-Umsetzers UCZ1T gelangt zu einem zweiten ZF-Umsetzer UCZ2T. Dieser Umsetzer UCZ2T wird von der mit einem Umsetzungsfaktor f' multiplizierten Frequenz des ersten Lokaloszillators LO4 angesteuert. Wie bereits im Zusammenhang mit der Basisstation ausgeführt, kann abweichend von dem dargestellten Ausführungsbeispiel der Teilnehmerstation auch nur eine oder es können auch mehr als zwei Zwischenfrequenzstufen vorgesehen werden.

Die Ausgangsfrequenz fCI2T des zweiten ZF-Umsetzers UCZ2T gelangt an den Eingang eines RF-Umsetzers UCRT. Die Referenzfrequenz für diesen RF-Umsetzers ist die mit einem Umsetzungsfaktor e' beaufschlagte Frequenz eines zweiten freilaufenden Lokaloszillators LO3. Am Ausgang des RF-Umsetzers UCRT steht die Sendeträgerfrequenz fCRT zur Verfügung.

Im Empfangszweig der Teilnehmerstation ist ein RF-Umsetzer UCRR vorhanden, dem die Empfangsträgerfrequenz fCRR zugeführt wird. Die Referenzfrequenz für diesen RF-Umsetzer ist wiederum die von dem zweiten Lokaloszillator LO3 erzeugte, mit einem Umsetzungsfaktor e multiplizierte Frequenz. Die Ausgangsträgerfrequenz fCI2R des RF-Umsetzers UCRR liegt am Eingang eines ZF-Umsetzers UCZ2R an. Dieser Umsetzer UCZ2R wird von der mit einem Umsetzungsfaktor f multiplizierten Frequenz des ersten Lokaloszillators LO4 angesteuert. Ähnlich wie im Sendezweig ist im Empfangszweig auch ein weiterer ZF-Umsetzer UCZ1R vorhanden. Dieser Umsetzer UCZ1R setzt die vom vorhergehenden ZF-Umsetzer UCZ2R gelieferte Trägerfrequenz fCI1R mit Hilfe der von dem ersten Lokaloszillator L04 stammenden und einem Umsetungsfaktor g multiplizierten Frequenz in eine Zwischenträgerfrequenz fCMR um. Es folgt ein Demodulator mit einem Umsetzer UCD, der das in die Zwischenfrequenzebene heruntergesetzte Empfangssignal demoduliert. Als Referenzfrequenz erhält der Umsetzer UCD die vom ersten Lokaloszillator LO4 erzeugte und mit dem Umsetzungsfaktor h multiplizierte Frequenz. Das demodulierte Empfangssignal y steht am Ausgang des Umsetzers UCD zur Verfügung.

Wenn man den Downlink betrachtet, d.h. die Datenübertragung von der Basisstation zur Teilnehmerstation, so ergibt sich aus der Eingangsfrequenz x des Sendezweiges der Basisstation und den Referenzfrequenzen für die Umsetzer UBM, UBZ1T, UBZ2T, UBRT und die Referenzfrequenzen für die Umsetzer UCRR, UCZ2R, UCZ1R und UCD des Empfangszweiges der Teilnehmerstation einer Ausgangsfrequenz y gemäß Gleichung (1).

$$x+LO1 \cdot a+LO1 \cdot b+L01 \cdot c+L02 \cdot d+L03 \cdot e+LO4 \cdot f+LO4 \cdot g+LO4 \cdot h = y \qquad (1)$$

Für den Uplink, das ist die Datenübertragungsrichtung von der Teilnehmerstation zur Basisstation, ergibt sich aus der Eingangsfrequen y' des Sendezweiges der Teilnehmerstation und den Referenzfrequenzen für die Umsetzer UCM, UCZ1T, UCZ2T, UCRT des Sendezweiges der Teilnehmerstation und den Referenzfrequenzen für die Umsetzer UBRR, UBZ2R, UBZ1R und UBD des Empfangszweiges der Basisstation eine Trägerfrequenz x' am Ausgang des Demodulators gemäß der Gleichung (2).

$$y'+LO4 \cdot h'+LO4 \cdot g'+LO4 \cdot f'+LO3 \cdot e'+LO2 \cdot d'+LO1 \cdot c'+LO1 \cdot b'+LO1 \cdot a' = x' \qquad (2)$$

Aus den Gleichungen (1) und (2) folgt:

$$x'-x = LO1 \cdot (a+b+c+a'+b'+c')+LO2 \cdot (d+d')+LO3 \cdot (e+e')+LO4 \cdot$$

$$(f+g+h+f'+g'+h')+y'-y \qquad (3)$$

Da die Sendefrequenzen x und y' der Basisstation und der Teilnehmerstation Basisbandsignale sind und deshalb per Definition 0 sind, folgt aus der Gleichung (3) die Gleichung (4).

$$x' = LO1 \cdot (a+b+c+a'+b'+c')+LO2 \cdot (d+d')+LO3 \cdot (e+e')+LO4 \cdot$$

$$(f+g+h+f'+g'+h') -y \qquad (4)$$

Ein Frequenzoffset in der Basisstation äußert sich darin, daß das Ausgangssignal x' des Demodulators UBD neben dem Basisbandsignal noch einen Trägerfrequenzanteil aufweist.

Ziel ist es, die Frequenzen so zu regeln, daß der Frequenzoffset in Form eines am Demodulatorausgang der Basisstation auftretenden Trägerfrequenzanteils verschwindet. Dieser Frequenzoffset wird allein dadurch ausgeregelt, daß die Umsetzungsfaktoren h und h' für den Demodulatorumsetzer UCD und den Modulatorumsetzer UCM in der Teilnehmerstation veränderbar sind und auf gewünschte Werte h'* und h* eingestellt werden. Die Veränderung der Umsetzungsfaktoren h und h' erfolgt durch einen Prozessor PZ. Zur Ausregelung des Frequenzoffsets regelt der Prozessor PZ den Umsetzungsfaktor h für den Umsetzer UCD des Demodulators auf einen solchen Wert h*, daß y = 0 wird, d.h. daß im Ausgangssignal des Demodulator-Umsetzers UCD kein Trägerfrequenzanteil mehr auftritt. Unter der Bedingung, daß y = 0 ist, kann die Gleichung (4) in Gleichung (5) umgeschrieben werden.

$$x' = LO1 \cdot (a+b+c+a'+b'+c') + LO2 \cdot (d+d') + LO3 \cdot (e+e') + LO4 \cdot$$

$$(f+g+h^*+f'+g'+h'^*) \tag{5}$$

Um den Frequenzoffset auszuregeln, ist es das Ziel x' = 0 zu erreichen, was bedeutet, daß im Ausgangssignal des Demodulators der Basisstation kein Trägerfrequenzanteil mehr vorhanden ist. In der Gleichung (5) wird x' = 0, wenn die Bedingungen gemäß den nachfolgenden Gleichungen (6), (7) und (8) erfüllt sind. Die Bedingungen in den Gleichungen (6) und (7) besagen, daß die Umsetzungsfaktor d, d' und e, e' für die RF-Umsetzer im Sende- und Empfangszweig der Basisstation und der Teilnehmerstation betragsmäßig gleich groß sein, aber entgegengesetzte Vorzeichen haben müssen. Das heißt, daß die Referenzfrequenzen für die Umsetzer im Sende- und Empfangszweig gleich sein, aber einen Phasenversatz von 180° haben müssen.

$$d = -d' \tag{6}$$

$$e = -e' \tag{7}$$

$$LO1 \cdot (a+b+c+a'+b'+c') + LO4 \cdot (f+g+h^*+f'+g'+h'^*) = 0 \tag{8}$$

Aus der Gleichung (8) ergibt sich der vom Prozessor PZ neu einzustellende Umsetzungsfaktor h'* für den Modulator UCM der Teilnehmerstation gemäß Gleichung (9).

$$h'^* = -\frac{LO1}{LO4} \cdot (a+b+c+a'+b'+c') - (f+g+h^*+f'+g') \tag{9}$$

Wenn für den Umsetzungsfaktor h'* die Gleichung (9) erfüllt ist, ist der Frequenzoffset in der Basisstation vollständig beseitigt, d.h. am Ausgang des Demodulators UBD tritt kein Trägerfrequenzanteil neben dem Basisbandsignal mehr auf.

Die in der Gleichung (9) auftretenden Lokaloszillatorfrequenzen LO1 und LO4 sind zwar vom nominellen Wert her bekannt, die tatsächlichen Abweichungen vom Sollwert kennt man aber nicht. Unter der Voraussetzung, daß von der Basisstation eine Symbolrate SRB gesendet wird, die aus dem Takt des Lokaloszillators LO1 abgeleitet ist, gilt:

$$SRB = \frac{LO1}{p} \tag{10}$$

In der Basisstation wird dann eine Symbolrate SRC gemäß Gleichung (11) empfangen, welche von der Zeitbasis des Lokaloszillators LO4 abhängt.

$$SRC = \frac{LO4}{q} \tag{11}$$

Da die Symbolrate durch keinen weiteren Lokaloszillator bestimmt wird, gilt:

$$SRB = SRC \tag{12}$$

Mit den Gleichungen (10), (11) und (12) gilt für die Faktoren p und q:

$$\frac{p}{q} = \frac{LO1}{LO4} \tag{13}$$

Der Faktor p ist ein in der Basisstation fest definierter Wert, der dem Prozessor PZ in der Teilnehmerstation bekannt ist. Den Faktor q ermittelt der Prozessor PZ dadurch, daß er aus dem Empfangssignal y die Symbolrate SRC ableitet und diese gemäß Gleichung (11) zu der ihm bekannten Systemtaktfrequenz des Lokaloszillators LO4 ins Verhältnis setzt.

Mit der Gleichung (13) ergibt sich aus der Gleichung (9) schließlich die Gleichung (14), gemäß der der Prozessor PZ den einzustellenden Umsetzungsfaktor h'* berechnet. Die in der Gleichung (14) vorkommenden Umsetzungsfaktoren a, b, c, a', b', c', f, g, f', g' sind feste Werte und dem Prozessor PZ bekannt. Außerdem hat er den neuen Umsetzungsfaktor h* für den Demodulator zuvor ermittelt.

$$h'^* = -\frac{p}{q} \cdot (a+b+c+a'+b'+c') - (f+g+h^*+f'+g') \tag{14}$$

Zwischen jeder der vorhandenen Teilnehmerstationen und der Basisstation wird die vorangehend dargelegte Frequenzsynchronisation durchgeführt.

Ein Vorteil der beschriebenen Ausregelung eines Frequenzoffsets in der Basisstation besteht darin, daß die Lokaloszillatoren freilaufend sein können. Außerdem ist eine flexible Auslegung der Umsetzungsfaktoren möglich, so daß ein recht großer Spielraum für die Wahl der Duplexfrequenzabstände gegeben ist.

**Patentansprüche**

1. Verfahren zum Ausregeln eines Frequenzoffsets im Empfänger einer Basisstation eines Nachrichtenübertragungssystems, in dem die Basisstation Nachrichten im Zeitmultiplex an mehrere Teilnehmerstationen aussendet und die Nachrichtenübertragung von den Teilnehmern zur Basisstation im Zeitmultiplex mit Vielfachzugriff erfolgt, **dadurch gekennzeichnet,**

   - **daß** in jeder Teilnehmerstation die Referenzfrequenz ihres Demodulators (UCD) so eingestellt wird, daß dessen Ausgangssignal (y) keinen Trägerfrequenzanteil aufweist,
   - **daß** aus der so eingestellten Referenzfrequenz für den Demodulator (UCD) in der betreffenden Teilnehmerstation und aus allen in dieser Teilnehmerstation und in der Basisstation fest vorgegebenen Umsetzer-Referenzfrequenzen eine Referenzfrequenz für den Modulator (UCM) in dieser Teilnehmerstation aus der Bedingung berechnet wird, daß eine im Ausgangssignal (x') des Demodulators (UBD) der Basisstation auftretende, einen Frequenzoffset darstellende Trägerfrequenz zu Null gesetzt wird,
   - und **daß** die Referenzfrequenz für den Modulator (UCM) der Teilnehmerstation auf den berechneten Wert eingestellt wird.

2. Verfahren nach Anspruch 1, **dadurch gekennzeichnet, daß** die Referenzfrequenz für den Modulator (UCM) der Teilnehmerstation aus der Bedingung berechnet wird, daß die Summe aus den Referenzfrequenzen für die Modulatoren (UBM, UCM), Demodulatoren (UBD, UCD) und Zwischenfrequenzumsetzer (UBZ1T, UBZ2T, UBZ1R, UBZ2R, UCZ1T, UCZ2T, UCZ1R, UCZ2R) in der Basisstation und in der Teilnehmerstation zu 0 gesetzt wird, wobei sowohl in der Basisstation als auch in der Teilnehmerstation die Referenzfrequenzen für die RF-Umsetzer (UBRT, UBRR, UCRT, UCRR) im Empfangs- und Sendezweig gleich aber gegenphasig sind.

3. Verfahren nach Anspruch 1, **dadurch gekennzeichnet, daß** in der Basisstation und in jeder Teilnehmerstation die Referenzfrequenzen für die Frequenzumsetzung im Modulator (UBM, UCM) und Demodulator (UBD, UCD) und für ein oder mehrere Zwischenfrequenzumsetzer (UBZ1T, UBZ2T, UBZ1R, UBZ2R, UCZ2T, UCZ1T, UCZ2T, UCZ1R, UCZ2R) von einem Lokaloszillator (LO1, LO4) durch Multiplikation der Lokaloszillatorfrequenz mit entsprechenden Umsetzungsfaktoren (a, b, c, a', b', c', e, f, g, e', f', g') gebildet werden und daß die Referenzenfrequenzen für RF-Umsetzer (UBRT, UBRR, UCRT, UCRR) von einem zweiten Lokaloszillator (LO2, LO3) durch Multiplikation der Lokaloszillatorfrequenz mit entsprechenden Umsetzungsfaktoren (d, d', e, e') erzeugt werden.

4. Verfahren nach Anspruch 3, **dadurch gekennzeichnet, daß** der Umsetzungsfaktor (h'*) für die Frequenzumsetzung im Modulator (UCM) der jeweiligen Teilnehmerstation aus der Bedingung berechnet wird, daß die Summe aus einem ersten Produkt, das durch Multiplikation der Lokaloszillatorfrequenz (LO1) der Basisstation mit der Summe aus den Umsetzungsfaktoren (a, a') für den Modulator (UBM) und den Demodulator (UBD) und den Zwischenfrequenz-Umsetzungsfaktoren (b, c, b', c') im Empfangs- und Sendezweig gebildet wird, und aus einem zweiten Produkt, das durch Multiplikation der Lokaloszillatorfrequenz (LO4) der Teilnehmerstation mit der Summe aus den Umsetzungsfaktoren (h', h) für den Modulator (UCM) und Demodulator (UCD) und den Zwischenfrequenz-Umsetzungsfaktoren (f, g, f', g') im Empfangs- und Sendezweig gebildet wird, zu Null gesetzt wird, wobei sowohl in der Basisstation als auch in der Teilnehmerstation die Umsetzungsfaktoren (d, d', e, e') für die RF-Umsetzer (UBRT, UBRR, UCRR, UCRT) im Empfangs- und Sendezweig vom Betrag her gleich groß sind aber entgegengesetzte Vorzeichen haben.

**5.** Verfahren nach Anspruch 4, **dadurch gekennzeichnet, daß** die Lokaloszillatorfrequenz (LO1) der Basisstation in der Teilnehmerstation aus der Symbolrate der von der Basisstation zur Teilnehmerstation übertragenen Daten hergeleitet wird.

## Claims

**1.** Method for regulating a frequency offset in the receiver of a base station of a data communications system in which the base station transmits data in time-division multiplex to a plurality of subscriber stations and the data transmission from the subscribers to the base station takes place in time-division multiplex with multiple access, **characterised in that** in each subscriber station, the reference frequency of its demodulator (CSD) is adjusted such that its output signal (y) has no carrier frequency component, that from the reference frequency thus adjusted for the demodulator (CSD) in the relevant subscriber station and from all converter reference frequencies predefined in this subscriber station and in the base station, a reference frequency for the modulator (CSM) in this subscriber station is calculated from the condition that a carrier frequency occurring in the output signal (x') of the demodulator (CBD) of the base station, representing a frequency offset, is set to zero, and that the reference frequency for the modulator (CSM) of the subscriber station is set to the calculated value.

**2.** Method according to claim 1, **characterised in that** the reference frequency for the modulator (CSM) of the subscriber station is calculated from the condition that the sum of the reference frequencies for the modulators (CBM, CSM), demodulators (CBD, CSD) and intermediate frequency converters (CBI1T, CBI2T, CBI1R, CBI2R, CSI1T, CSI2T, CSI1R, CSI2R) in the base station and in the subscriber station is set to zero, whereby both in the base station and in the subscriber station, the reference frequencies for the RF converters (CBRT, CBRR, CSRT, CSRR) in the transmitting and receiving limbs are equal but antiphase.

**3.** Method according to claim 1, **characterised in that** in the base station and in each subscriber station, the reference frequencies for the frequency conversion in the modulator (CBM, CSM) and demodulator (CBD, CSD) and for one or more intermediate frequency converters (CBI1T, CBI2T, CBI1R, CBI2R, CSI1T, CSI2T, CSI1R, CSI2R) are formed by a local oscillator (LO1, LO4) by multiplication of the local oscillator frequency by suitable conversion factors (a, b, c, a', b', c', e, f, g, e', f', g') and that the reference frequencies for the RF converters (CBRT, CBRR, CSRT, CSRR) are generated by a second local oscillator (LO2, LO3) by multiplication of the local oscillator frequency by suitable conversion factors (d, d', e, e').

**4.** Method according to claim 3, **characterised in that** the conversion factor (h'*) for the frequency conversion in the modulator (CSM) of the respective subscriber station is calculated from the condition that the sum of a first product formed by multiplication of the local oscillator frequency (LO1) of the base station by the sum of the conversion factors (a, a') for the modulator (CBM) and the demodulator (CBD) and the intermediate frequency conversion factors (b, c, b', c') in the receiving and transmitting limbs, and a second product formed by multiplication of the local oscillator frequency (LO4) of the subscriber station by the sum of the conversion factors (h', h) for the modulator (CSM) and the demodulator (CSD) and the intermediate frequency conversion factors (f, g, f', g') in the receiving and transmitting limbs is set to zero, whereby both in the base station and in the subscriber station, the conversion factors (d, d', e, e') for the RF converters (CBRT, CBRR, CSRR, CSRT) in the receiving and transmitting limbs are of equal size, but opposite sign.

**5.** Method according to claim 4, **characterised in that** the local oscillator frequency (LO1) of the base station is derived in the subscriber station from the symbol rate of the data transmitted from the base station to the subscriber station.

**Revendications**

1. Procédé destiné à régler parfaitement un décalage de fréquence dans le récepteur d'une station de base d'un système de transmission d'informations, dans lequel sont émises dans la station de base des informations en multiplexage temporel à plusieurs stations d'abonné, et dans lequel la transmission d'informations des abonnés à la station de base se fait en multiplexage temporel avec accès multiple, **caractérisé en ce que**,

   - dans chaque station d'abonné la fréquence de référence de leur démodulateur (UCD) est réglée de sorte que le signal de sortie (y) du démodulateur ne présente pas de composante de la fréquence de la porteuse,
   - à partir de la fréquence de référence ainsi réglée pour le démodulateur (UCD) dans la station d'abonné concernée et à partir de toutes les fréquences de référence prédéterminées des convertisseurs dans cette station d'abonné et dans la station de base est calculée pour le modulateur (UCM) dans cette station d'abonné une fréquence de référence à partir de la condition que soit mise à zéro une fréquence de la porteuse représentant un décalage de fréquence apparaissant dans le signal de sortie (x') du démodulateur (UBD) de la station de base,
   - et que la fréquence de référence pour le modulateur (UCM) de la station d'abonné est réglée sur la valeur calculée.

2. Procédé selon la revendication 1, **caractérisé en ce que** la fréquence de référence pour le modulateur (UCM) de la station d'abonné est calculée à partir de la condition que soit mise à zéro la somme des fréquences de référence pour les modulateurs (UBM, UCM), pour les démodulateurs (UBD, UCD) et pour les convertisseurs de fréquence intermédiaire (UBZ1T, UBZ2T, UBZ1R, UBZ2R, UCZ1T, UCZ2T, UCZ1R, UCZ2R) dans la station de base et dans la station d'abonné, moyennant quoi, aussi bien dans la station de base que dans la station d'abonné, les fréquences de référence pour les convertisseurs RF (UBRT, UBRR, UCRT, UCRR) sont identiques mais en opposition de phase dans les branches réceptrice et émettrice.

3. Procédé selon la revendication 1, **caractérisé en ce que**, dans la station de base et dans chaque station d'abonné, les fréquences de référence pour la conversion de fréquence dans le modulateur (UBM, UCM) et dans le démodulateur (UBD, UCD) et pour un ou plusieurs convertisseurs de fréquence intermédiaire (UBZ1T, UBZ2T, UBZ1R, UBZ2R, UCZ2T, UCZ1T, UCZ2T, UCZ1R, UCZ2R) sont formées par un oscillateur local (LO1, LO4) en multipliant la fréquence de l'oscillateur local par des facteurs de conversion appropriés (a, b, c, a', b', c', e, f, g, e', f', g') et que la fréquence de référence pour le convertisseur RF (UBRT, UBRR, UCRT, UCRR) est générée par un deuxième oscillateur local (LO2, LO3) en multipliant la fréquence de l'oscillateur local par des facteurs de conversion appropriés (d, d', e, e').

4. Procédé selon la revendication 3, **caractérisé en ce que** le facteur de conversion (h'*) pour la conversion de fréquence dans le modulateur (UCM) de chaque station d'abonné est calculé à partir de la condition que soit mise à zéro la somme :

   d'un premier produit, qui est formé par la multiplication de la fréquence de l'oscillateur local (LO1) de la station de base par la somme des facteurs de conversion (a, a') pour le modulateur (UBM) et pour le démodulateur (UBD) et des facteurs de conversion (b, c, b', c') de la fréquence intermédiaire dans les branches réceptrice et émettrice,
   et d'un deuxième produit, qui est formé par la multiplication de la fréquence de l'oscillateur local (LO4) de la station d'abonné par la somme des facteurs de conversion (h', h) pour le modulateur (UCM) et pour le démodulateur (UCD) et des facteurs de conversion (f, g, f', g') de la fréquence intermédiaire dans les branches réceptrice et émettrice, moyennant quoi, aussi bien dans la station de base que dans la station d'abonné, les facteurs de conversion (d, d' ; e, e') pour les convertisseurs RF (UBRT, UBRR, UCRR, UCRT) dans les branches réceptrice et émettrice ont le même montant mais sont de signe opposé.

5. Procédé selon la revendication 4, **caractérisé en ce que** la fréquence de l'oscillateur local (LO1) de la station de base est déduite, dans la station d'abonné, du débit de symboles des données transmises par la station de base à la station d'abonné.

Fig.1

Fig.2